# EUROPEAN PATENT APPLICATION

(11) **EP 4 646 927 A1**
(43) Date of publication of application: **12.11.2025**
(21) Application number: 24382501.5
(22) Date of filing: 07.05.2024
(51) Int. Cl.: A01K 61/70, E02B 3/04

(54) **COMPUTER IMPLEMENTED METHOD OF DESIGNING ARTIFICIAL REEFS**

(71) Applicant: Underwater Gardens International, S.L., 08008 Barcelona Barcelona (ES)
(72) Inventor: García-Durán Huet, Marcos, 08014 BARCELONA (ES)
(74) Representative: Espiell Gomez, Ignacio

(57) **Abstract**

Computer implemented method of designing artificial reefs (2), comprising the steps of i) analysing geographic data (3) of a selected site (1); ii) generating of a terrain 3D model (5) of the selected site (1) from the geographic data (3); iii) determining restrictions (41) in the terrain 3D model (5); iv) determining an optimized area (42) in the terrain 3D model (5); v) determining an optimized layout (43) of landing points (51) in the terrain 3D model (5), aimed specifically to a system or a method developed as a setup of self-learning algorithms, which allows it to perform and evolve in an sea open-ended environment.

## Description

### TECHNICAL FIELD OF THE INVENTION

Computer implemented method of designing artificial reefs, comprising the steps of analysing geographic data of a selected site, generating of a terrain 3D model, determining its restrictions, determining an optimized area and an optimized layout of landing points, according to claims 1 to 15, incorporating notable innovations and advantages over technical solutions used so far.

### BACKGROUND OF THE INVENTION

It is currently known that an artificial reef is a human-created structure for different purposes as to promote marine life, to control erosion, to protect coastal areas, to block ship passage, to block the use of trawling nets, to support reef restoration, to improve aquaculture, or to enhance scuba diving and surfing.

A conventional artificial reef uses materials such as concrete, which can be moulded into specialized forms. Alternatively artificial reefs may incorporate renewable and organic materials such as vegetable fibres and seashells to improve sustainability and reduce energy consumption, pollution, and greenhouse gas emissions.

Artificial reefs generally provide hard surfaces where algae and invertebrates such as barnacles, corals, and oysters attach and spaces where different sizes of fishes can hide. The accumulation of attached marine life in turn provides intricate structures and food for assemblages of fish. The ecological impact of an artificial reef depends on multiple factors including where it is situated, how it is constructed, and the types of marine species involved.

A patent related to the present invention is the CN117481058, which describes a special tetrahedron type artificial fish reef body for accumulation. The body is a tetrahedron frame structure enclosed by six support rods, any one of four surfaces of the tetrahedron frame structure is triangular, and four intersection points of the tetrahedron frame structure are respectively provided with an extension rod. The extension rods arranged at the four intersection points of the tetrahedral frame structure and the three intersected supporting rods are integrally formed. The stability of the fish reef single bodies is improved, and the overall stability of the artificial fish reef accumulation body is improved. The height of the stacking body can be effectively increased, and the stacking body has the advantages of firmness and higher stacking height.

Another patent related to the present invention is the CN220402772, which describes an artificial fish reef which comprises a main semicircular component, auxiliary semicircular components are arranged on the two sides of the main semicircular component. The main semicircular component and the auxiliary semicircular components are fixedly connected through transverse reinforced concrete slabs. A plurality of preformed holes is formed in the main semicircular component, and the main semicircular component and the auxiliary semicircular components are fixedly connected through the transverse reinforced concrete slabs.

However, there are no prior art disclosures aimed specifically to a system or a method developed as a setup of self-learning algorithms, which allows it to perform and evolve in an sea open-ended environment.

### DESCRIPTION OF THE INVENTION

The present invention is related to a system, and in particular, a computer implemented method of designing artificial reef with the capability to create a great positive impact on the marine environment and the local economy. This system acts as a platform where engineering, marine biology, architecture, and economical requirements of any given site can be analyzed, thus providing evolutionary and iterative design solutions.

The present invention integrates the capability of data mining GIS (Geographical Information Systems) data and processing it with customized algorithms designed by marine biologists, engineers, architects, and economists for intelligent artificial reef designs. The system is conceived on a multi layered design thinking approach, which generated flexible platforms within the system for the experts from various fields to get involved and allowed to create a strategic and symbiotic knowledge sharing environment.

The invention comprises a design library, being a collection of the artificial reef designs that has been developed by collaborations with biologists, engineers, artists, architects, and computational designers as well as based on the provided parameters related to specific site conditions, the algorithms in the system can create a set of customized evolutionary reef designs and their distribution layouts. It consists of designs at various scales and typologies ranging from simple polyhedrons to complex organic structures. Each design has been studied and calibrated in terms of its biological impact, user experience, materiality, fabrication, assembly, and execution. The development and evolution of these designs is a collaborative approach with an evolutionary and adaptive vision thus the algorithms used to achieve this operates in a self-learning methodology. In addition to Smart evolutionary reef designs and their distribution strategies, the system is also capable of creating systems such as modular reefs with the possibility of stacking, Interlocking reefs responding to avoiding erosion, and strategies of distribution for gamification.

GIS data of the location of existing natural reefs are translated into the algorithms from numericals to raster and vector format. Raster information is read and translated from pixels to co-ordinate system, whereas other vector based information is read as it is. These images are read within the algorithm as pixels and converted to co-ordinate system, This is overlayed on the terrain geometry and used as filters to optimize the area selection of new interventions. Based on the programmatic and site requirements, the algorithms can be shifted from scientific purpose or restorative purpose of the project.

Regarding the coastal hydrodynamics current, the information regarding the velocity of the current at various depths is analysed to determine the height of the interventions. The height of the intervention is also optimized for structural stability based on the wavelength and the depth of the seabed. And formal morphology of the intervention can be adapted based on the bionomical requirement of the site resulting into creating resistance to the current at varied degrees. This result is translated into graphs and charts for further analysis while monitoring.

Regarding sedimentology and sediment dynamics, a CFD (Computational Fluid Dynamics) Analysis serves to optimize locations for voxels where there will be high retention of nutrients that will feed the sessile species. Also to optimize locations to avoid too high sediment retention rates that might bury the voxels, rendering them useless.

Regarding the slope requirements, as slopes higher than 15° will be considered unsuitable for the installation of artificial reefs, due to low stability and high risk of displacements, the terrain is analysed and filtered to select the areas with less than 15°.

And regarding the light availability, just to mention that light availability is heavily influenced by the location depth of the voxels. Turbidity in the area will affect the light received by a certain area in a voxel. Raster map of satellite images are read within the algorithms as pixels and the RGB values are translated into vector to determine and optimize the morphology and the distribution of artificial reefs.

More particularly, computer implemented method of designing artificial reefs comprises the steps of i) analysing geographic data of a selected site; ii) generating of a terrain 3D model of the selected site from the geographic data; iii) determining restrictions in the terrain 3D model; iv) determining an optimized area in the terrain 3D model; v) determining an optimized layout of landing points in the terrain 3D model. This allows implementing marine restoration strategies, by means of the setup of self-learning algorithms. It is a design protocol algorithm to analyse, design, implement, evaluate, and monitor marine restoration strategies. The algorithm is also used to design artificial reefs that will play a key role in most marine restoration strategies. It also allows integrating more complexity when designing marine restoration strategies.

It is worth mentioning that the geographic data comprises abiotic data and/or biotic data and/or terrain data and/or project logistical data, such that the design of the artificial reef can very precisely adapted to the marine environment.

More specifically, the abiotic data comprises any of the group of topography, velocity of currents, direction of currents, height of waves, velocity of wind, direction of wind, direction of waves, turbidity, seabed substrate type, sediment deposit height, mean depth, seabed accumulation rate, velocity for species, lighting and protected areas, such that the design of the artificial reef can very precisely adapted to specific physical conditions of the marine environment.

Additionally, the biotic data comprises any of the group of larval dispersion extent, larval dispersion rate, coralliferous habitats, type of species, proximity of existing species and protected species, such that the design of the artificial reef can very precisely adapted to specific biological conditions of the marine environment.

On the other hand, the terrain data comprises any of the group of existing ports and diving areas, such that the design of the artificial reef can very precisely adapted to specific needs of the visitors to the area, and fulfil their expectations.

According to another aspect of the invention, the terrain 3D model of the selected site is a format of a mesh model or NURBS model. In particular a 3D mesh model is a 3D representation of an object that consists of a collection of faces, edges and vertices that define the object's shape and structure in a fairly realistic way. Each edge connects two adjacent vertices, which are themselves coordinates or points in the 3D space. In addition, a non-uniform rational basis spline (NURBS) is a mathematical model using basis splines (B-splines) that is commonly used in computer graphics for representing curves and surfaces. It offers great flexibility and precision for handling both analytic, defined by common mathematical formulae, and modelled shapes.

Complementarily, the restrictions in the terrain 3D model are any of the group of required depth, substrate type, protected areas, emissaries presence and seabed slope, such that the design of the artificial reef can very precisely adapted to the marine environment. An underwater emissary, in the field of sanitary engineering, is a conduit through which the wastewater is pumped, after a primary treatment, to conduct it at a certain distance from the coast. At the end of the pipe a section of perforated tube is installed, called a diffuser, which facilitates the diffusion of the water served in the receiving body.

In a preferred embodiment of the invention, determining an optimized area comprises aligning the landing points along the sea current, in a parallel direction, such that the artificial reefs are not opposed to the sea current, and therefore the interference with the natural environment is minimum, and also, the durability of the artificial reefs is greater.

Advantageously, determining an optimized area comprises positioning the landing points according to the distance from the shore and/or to the seabed type, such that the landing points of the artificial reefs are located at an adequate distance for being accessible sailing from the coast. Also the consistency of the seabed has to be taken into account for a proper settlement of the artificial reef.

Besides, determining an optimized area comprises determining amount of the landing points based on the number and/or size of the boats to be moored, such that the landing points of the artificial reefs are adequate for the expectations of the visitors.

According to another aspect of the invention, determining an optimized area comprises avoiding at least one topographic boundary and/or at least one intersection event. Topographic boundaries are defined by the size and they are calculated by the previous optimization methods. Intersection events are triggered when the developed cells for hard transplantation of distribution either lay outside or on the topographic boundary and/or on the discarded topographic area, i.e.: rocky seabed, within the topographic boundary.

Additionally, determining an optimized area comprises maintaining a distance between landing points, within minimum and maximum limits, for an ease access and safety of the boats.

More particularly, determining an optimized layout of landing points comprises the steps of i) selecting a first cell; ii) analysing a plurality of adjacent second cells; iii) calculating the fractal dimension of each combination of the first cell with the plurality of adjacent second cells, with a box counting method; iv) selecting a second cell which creates a highest fractal dimension, therefore arriving to an optimal distribution of the landing points, according to precise mathematical calculations.

In summary, to calculate the fractal dimension a box counting method is used, establishing a combination of cell A and each one of its adjacent cells, therefore obtaining the fractal dimension of cells A and B, cells A and C, and cells A and D. A specific algorithm chooses the maximum fractal dimension between a cell and the combination of each of its adjacent cells, via the box counting method which comprises a fixed grid, no rotation, and an exponential decrease in the size of boxes. The algorithm jumps every time a cell has less than two free adjacent cells, and it fully stops when it reaches a predefined maximum area.

Regarding the fractal dimension calculator, the definition starts by dividing the whole selected surface into a Voronoi diagram. The initial area is evenly populated with several random points. The density of points will determine the average size of each cell. In the current definition, the average size of each cell is set at number of m². A simple Voronoi cell algorithm is applied, using the random points as an input inside the perimeter of the initial area.

Regarding the selection of first point, the first cell from where the fractal calculator will start is chosen either randomly, or it is implemented a feature that will choose the cell closest to the first landing point. The first landing point is the first one following the vector of the predominant current, as the initial cell from which to initiate the fractal calculator.

In addition, from the fractal dimension calculator, the possible candidates from the starting cell, are only the cells which are adjacent to the initial one. For this example, cell A will be the starting cell. Cells B, C and D are cell A's only adjacent cells. For calculating the fractal dimension, the box counting methodology will be used due to its ease of use and compatibility with a preferred computational program. It is a box counting method employing fixed grid scans, no rotation or superposition, and an exponential decrease in box size. The following step is to calculate the fractal dimension, via box counting method, of the combination of cell A and each one of its adjacent cells (fractal dimension of cells A and B, cells A and C, and cells A and D). The combination with the highest fractal dimension is selected, and the algorithm starts again. If, say, the combination of cells A and D is the one with the highest fractal dimension, cell D will be the new starting point. Cells E, F and G are the next adjacent cells. The algorithm will then calculate the fractal dimension of combinations ADE, ADF and ADG. The one with the highest fractal dimension will be chosen, and the last cell to be added will be the next starting point. The algorithm will continue working until for any given combination, there are less than two adjacent cells available. The calculator stops and the definition jumps to a new random cell, and the fractal calculator algorithm starts again. The whole definition stops once it reaches a previously defined cumulative area.

Complementarily, it can be added a feature to stop the fractal calculator once a certain combination of cells reaches a previously defined size. Also adding a feature to have more control over the next random point selected to start the fractal calculator again (a certain distance in the direction of the current, or a certain distance to the next landing point, for example). Adding the above mentioned feature of having more control over the first cell that will initiate the fractal dimension calculator.

According to a preferred embodiment of the invention, the previous steps are repeated until covering the total extension of the optimized area, such that, iteratively, it is reached an optimal design. The algorithms are engineered with the capacity to perform rule-based iterations by analysing the environmental and economic impact of the design on the site and thus optimizing them to maximise the positive potential of the designs, reaching a highly efficient machine-learning setup and hence aligning it with the envisioned purpose of being a self-evolutionary system. Therefore the present invention is a system that not only provides the context-based designs with the topographical, biological, and economical requirements. It also operates as a system where the designs can be studied and analyzed over a long period of time, thus collecting, and providing a structure of data to explore the future possibilities of underwater design ecologies.

The condition of being iterative allows a self-learning and evolving system which refines the overall bionomic design process and the primary categories based on the behavioural analysis of the output and the site's ecosystem. It operates as a multi-layered reflexive system with the possibility to accommodate programmatic requirements at simple and complex levels.

It should be noted that the cell comprises a structural reef or a plant, such it gives more flexibility to the design of the artificial reef. The cell is a region defined for a structural reef or collection of reefs or a region for soft bottom transplantation, particularly a plant.

The present invention also relates to an artificial reef designed by a computer implemented method of designing artificial reefs, according to what it is described above.

In the attached drawings it is shown, by way of non-limiting example, a computer implemented method of designing artificial reefs, constituted according to the invention. Other characteristics and advantages of said computer implemented method of designing artificial reefs, object of the present invention will become apparent from the description of a preferred, but not exclusive, embodiment that is illustrated by way of non-limiting example in the accompanying drawings, in which:

### BRIEF DESCRIPTION OF THE DRAWINGS

Figure 1.- Is view of a geographic selected site suitable for a design of an artificial reef, in accordance with the present invention.
Figure 2A.- Is a diagram including geographic data of the selected site, in accordance with the present invention.
Figure 2B.- Is a diagram including geographic data and a first 3D model of the selected site, in accordance with the present invention.
Figure 2C.- Is a diagram including geographic data and a second 3D model of the selected site, in accordance with the present invention.
Figure 2D.- Is a diagram including geographic data and a third 3D model of the selected site, in accordance with the present invention.
Figure 3A.- Is a diagram including geographic data of the selected site including the sea current, in accordance with the present invention.
Figure 3B.- Is a diagram including geographic data of the selected site including some landing points, in accordance with the present invention.
Figure 3C.- Is a diagram including geographic data of the selected site including some landing points, in accordance with the present invention.
Figure 3D.- Is a diagram including geographic data of the selected site including an optimized area, in accordance with the present invention.
Figure 3E.- Is a diagram including geographic data of the selected site including an optimized area, in accordance with the present invention.
Figure 4.- Is a diagram including geographic data of the selected site including an optimized area, in accordance with the present invention.
Figure 5.- Is a diagram including an optimized layout with cells, in accordance with the present invention.
Figure 6A.- Is a diagram of the process for determining a first optimized layout, in accordance with the present invention.
Figure 6B.- Is a diagram of the process for determining a second optimized layout, in accordance with the present invention.
Figure 7.- Is a diagram of an optimized layout with artificial reefs, in accordance with the present invention.
Figure 8A.- Is a diagram of a first optimized layout with structural reefs and plants, in accordance with the present invention.
Figure 8B.- Is a diagram of a second optimized layout with structural reefs and plants, in accordance with the present invention.
Figure 9.- Is a perspective of an optimized layout with structural reefs and plants, in accordance with the present invention.

### DESCRIPTION OF A PREFERRED EMBODIMENT

In view of the aforementioned figures and, according to the numbering adopted, a preferred embodiment of the invention can be seen in them, which comprises the parts and elements indicated and described in detail below.

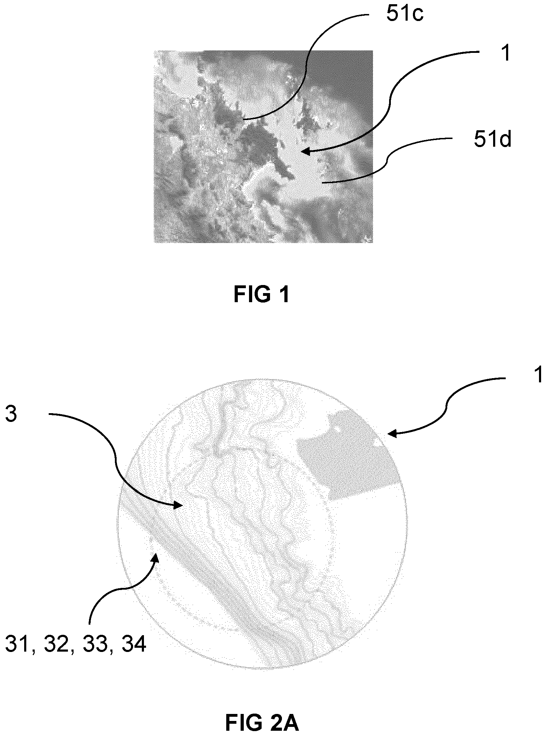

Figure 1 illustratively shows a view of a geographic selected site (1) suitable for a design of an artificial reef (2). It can be seen the location of the shore (51c) and of the seabed (51d).

Figure 2A illustratively shows a diagram including geographic data (3) of the selected site (1), geographic data (3) that comprises abiotic data (31), biotic data (32), terrain data (33) and logistical data (34).

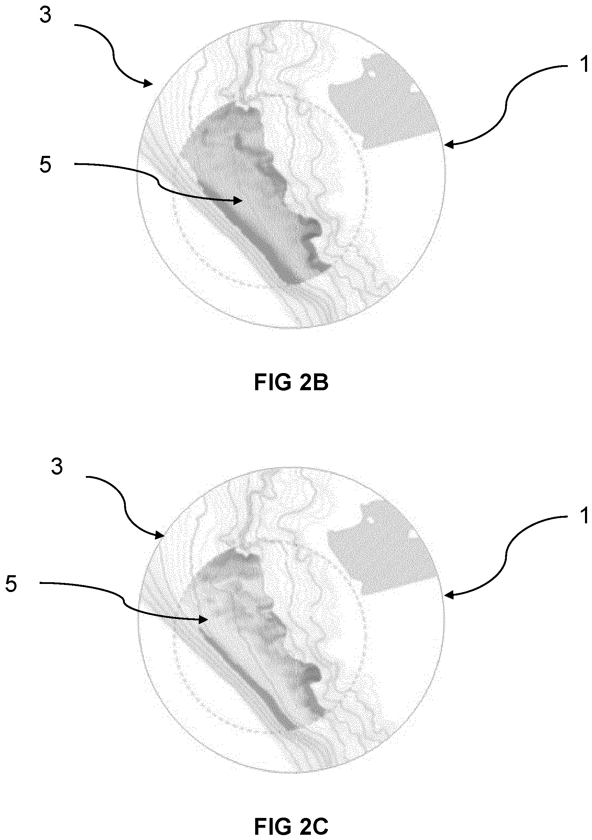

Figure 2B illustratively shows a diagram including geographic data (3) and a first 3D model (5) of the selected site (1).

Figure 2C illustratively shows a diagram including geographic data (3) and a second 3D model (5) of the selected site (1).

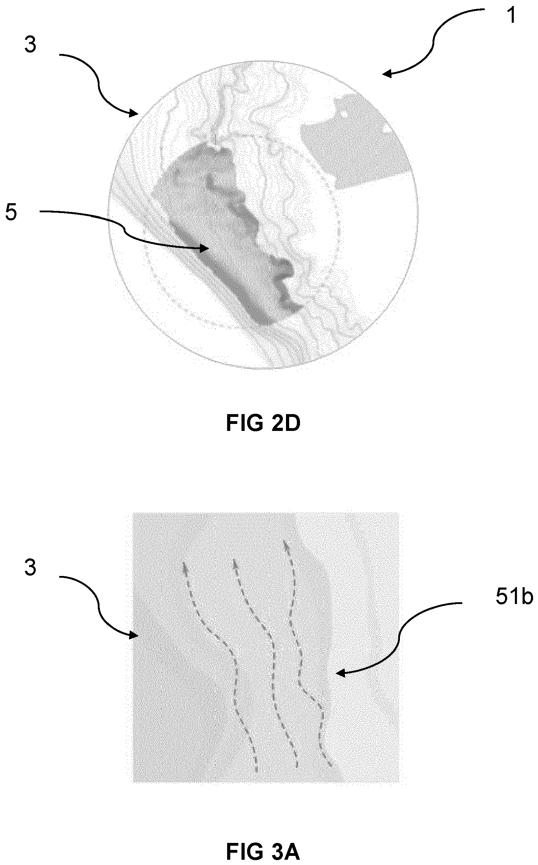

Figure 2D illustratively shows a diagram including geographic data (3) and a third 3D model (5) of the selected site (1).

Figure 3A illustratively shows a diagram including geographic data (3) of the selected site (1) including the sea current (51b).

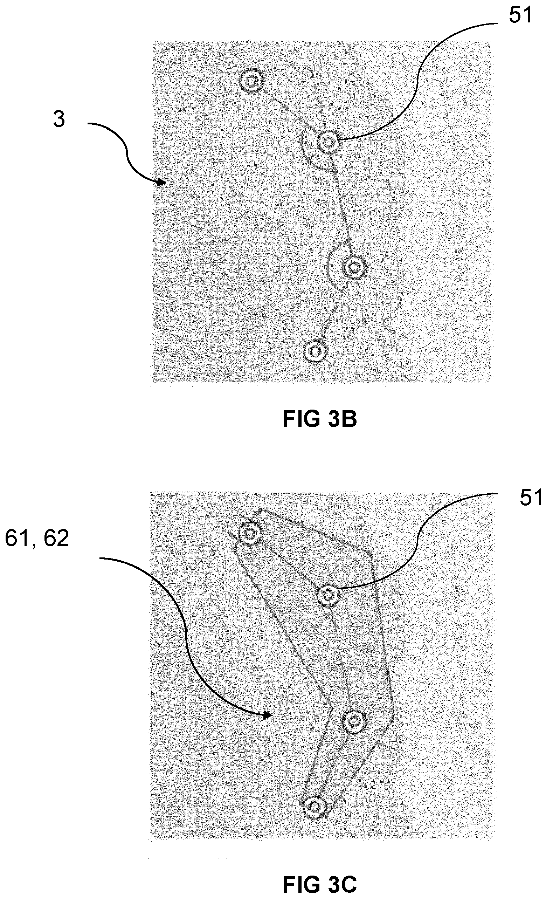

Figure 3B illustratively shows a diagram including geographic data (3) of the selected site (1) including some landing points (51), following the criteria of aligning the disposition of said landing points (51) along the sea current (51b)

Figure 3C illustratively shows a diagram including geographic data (3) of the selected site (1) including some landing points (51), in accordance with the present invention, following the criteria of identifying and avoiding topographic boundaries (61) and intersection events (62).

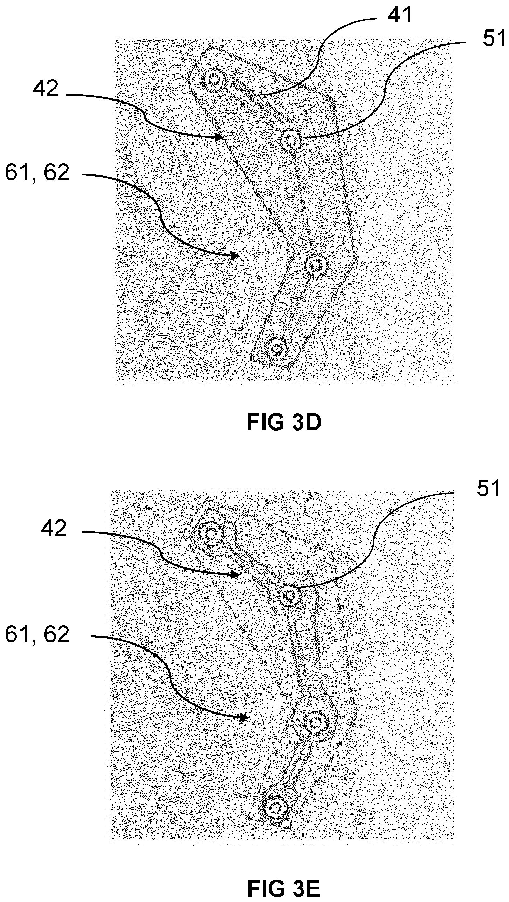

Figure 3D illustratively shows a diagram including geographic data (3) of the selected site (1) including an optimized area (42), following the criteria of satisfying a condition or restriction (41) for maintaining a certain distance between landing point (51) within minimum and maximum limits.

Figure 3E illustratively shows a diagram including geographic data (3) of the selected site (1) including an optimized area (42), following the criteria of keeping a minimum distance around the artificial reef (2) for ease of access and safety, which also represent an increase on the area of the plaza.

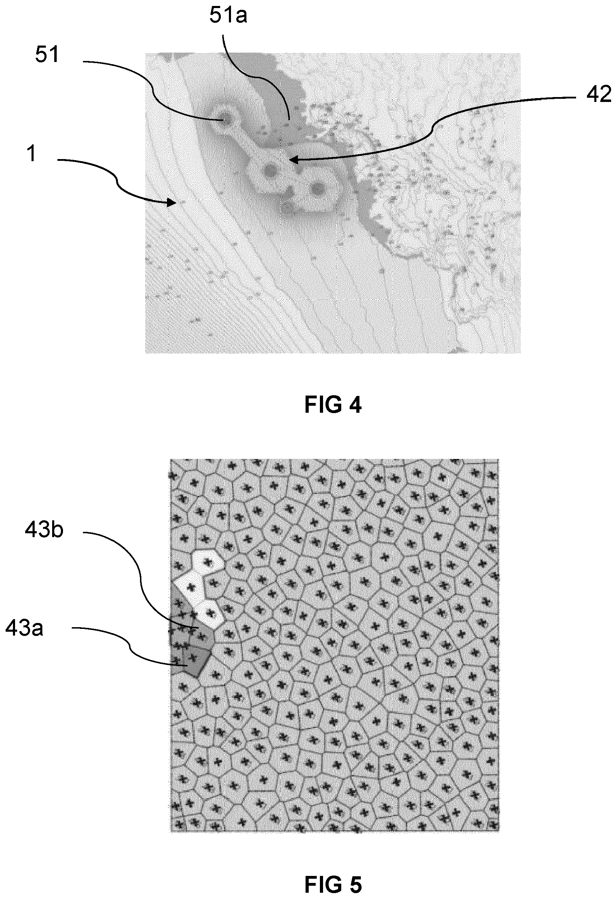

Figure 4 illustratively shows a diagram including geographic data (3) of the selected site (1) including an optimized area (42), comprising the landing points (51), as the place for docking the boats (51a).

Figure 5 illustratively shows a diagram including an optimized layout (43) with cells (43a, 43b)

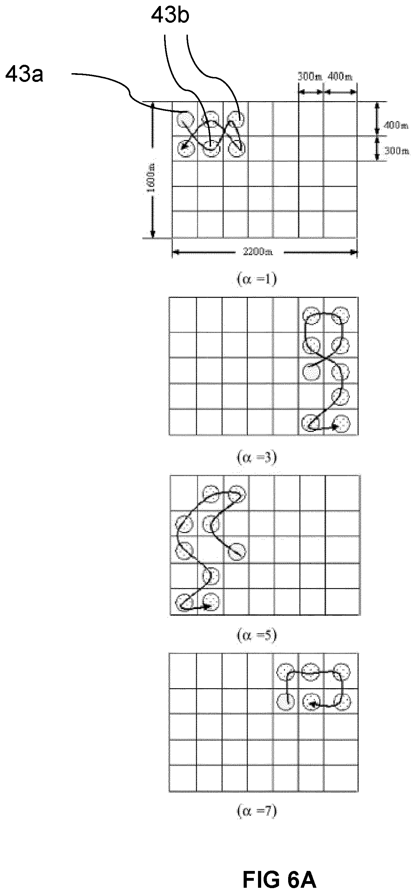

Figure 6A illustratively shows a diagram of the process for determining a first optimized layout (43) with a first cell (43a) and a second cell (43b).

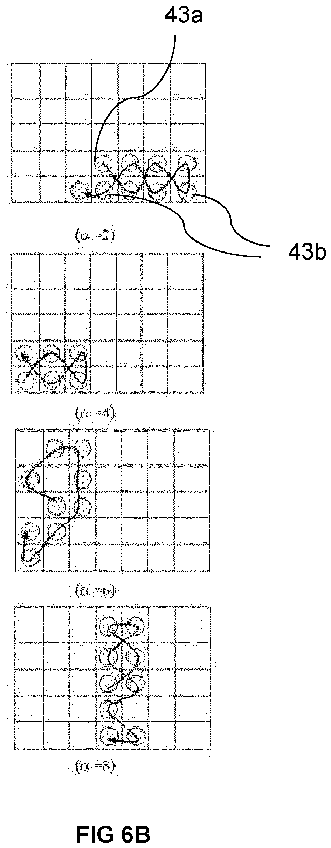

Figure 6B illustratively shows a diagram of the process for determining a second optimized layout (43) with a first cell (43a) and a second cell (43b).

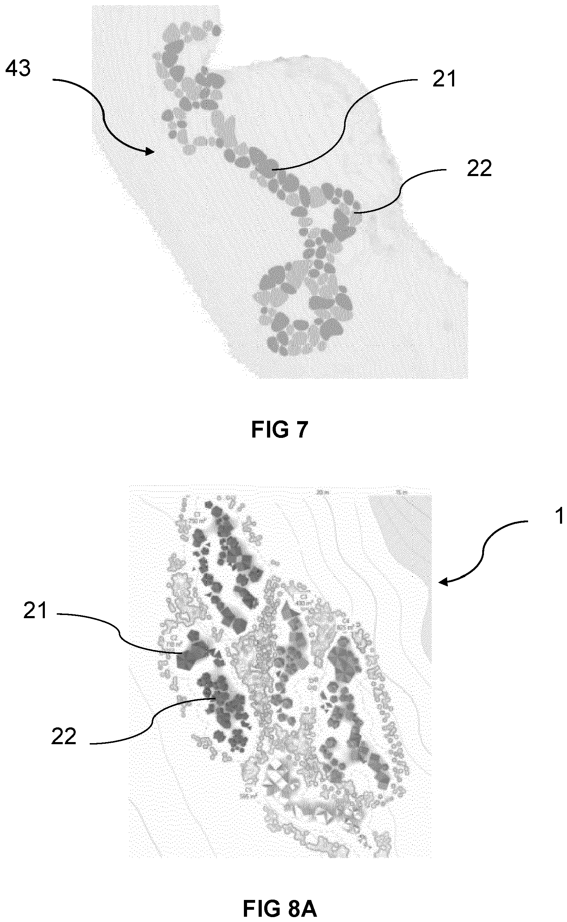

Figure 7 illustratively shows a diagram of an optimized layout (43) with artificial reefs (2) including structural reefs (21) and plants (22).

Figure 8A illustratively shows a diagram of a third optimized layout (43) with artificial reefs (2) including structural reefs (21) and plants (22).

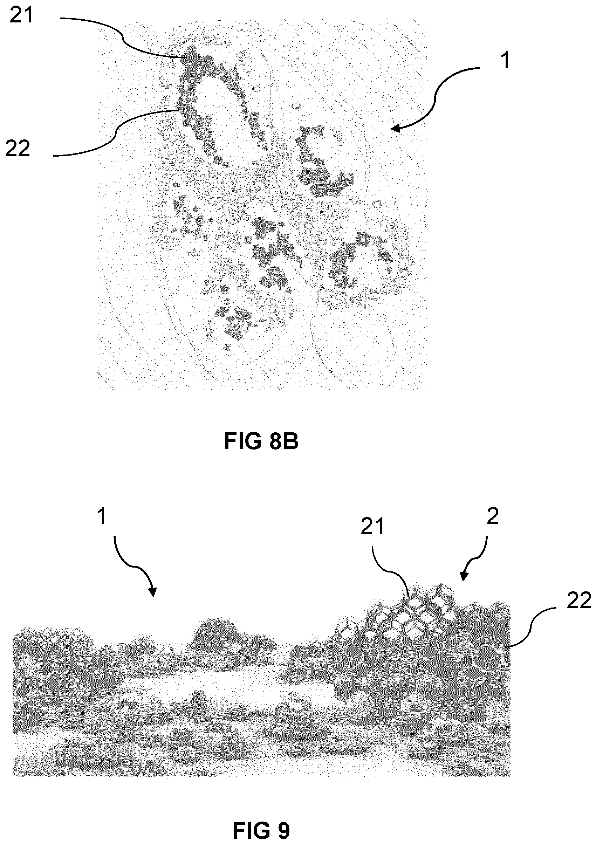

Figure 8B illustratively shows a diagram of a fourth optimized layout (43) with artificial reefs (2) including structural reefs (21) and plants (22).

Figure 9 illustratively shows a perspective of an optimized layout (43) of a site (1) with artificial reefs (2) including structural reefs (21) and plants (22).

More particularly, according to figures 2A and 4, the computer implemented method of designing artificial reefs (2), comprises the steps of i) analysing geographic data (3) of a selected site (1); ii) generating of a terrain 3D model (5) of the selected site (1) from the geographic data (3); iii) determining restrictions (41) in the terrain 3D model (5); iv) determining an optimized area (42) in the terrain 3D model (5); v) determining an optimized layout (43) of landing points (51) in the terrain 3D model (5), wherein the geographic data (3) comprises referenced information, that helps to determine the position of landing points (51). In addition said position of the landing points (51) are determined by the logistics of the project, also based on the number and size of the boats (51a), so that the landing points (51) can be increased or reduced. The position of the landing points (51) can be determined too by the distance from the shore (51c), filtered topography area based on seabed (51d) type and direction of the sea current (51b).

Additionally, according to figure 2A, the geographic data (3) comprises abiotic data (31) and/or biotic data (32) and/or terrain data (33) and/or project logistical data (34). Said information is collected through various channels such as open-source platforms/websites, self-diving by UGI team to collect data, services provided by consultants, and/or documentation of the location from archives of local centres.

More precisely, according to figure 2A, the abiotic data (31) comprises any of the group of topography, velocity of currents, direction of currents, height of waves, velocity of wind, direction of wind, direction of waves, turbidity, seabed (51d) substrate type, sediment deposit height, mean depth, seabed (51d) accumulation rate, velocity for species, lighting and protected areas.

Besides, according to figure 2A, the biotic data (32) comprises any of the group of larval dispersion extent, larval dispersion rate, coralliferous habitats, type of species, proximity of existing species and protected species.

Furthermore, according to figure 2A, the terrain data (33) comprises any of the group of existing ports and diving areas.

According to another aspect of the invention, and according to figures 2C and 2D, the terrain 3D model (5) of the selected site (1) is a format of a mesh model or NURBS model.

It should be noted that, according to figures 1 and 3D, the restrictions (41) in the terrain 3D model (5) are any of the group of required depth, substrate type, protected areas, emissaries presence and seabed (51d) slope.

Complementarily, according to figures 3A and 3B, determining an optimized area (42) comprises aligning the landing points (51) along the sea current (51b). The sea current (51b) influences the definition of landing points (51), and location of the hard, soft elements, based on the gamification aspect of the project. Since flowing along the sea current (51b) is easier and divers can perform longer and easier dives while diving in the direction of the current, hence the landing points (51) are to be placed in such fashion. Location of hard and soft elements also get influenced by the flow of the sea current (51b) with respect to bionomical connectivity, as transmission of biotic data is better along the flow of the current.

More specifically, according to figure 3D, determining an optimized area (42) comprises positioning the landing points (51) according to the distance from the shore (51c) and/or to the seabed (51d) type.

In a preferred embodiment of the invention, according to figures 3E and 4, determining an optimized area (42) comprises determining amount of the landing points (51) based on the number and/or size of the boats (51a) to be moored.

Advantageously, according to figure 3C, determining an optimized area (42) comprises avoiding at least one topographic boundary (61) and/or at least one intersection event (62). Also determining an optimized area (42) comprises maintaining a distance between landing points (51), within minimum and maximum limits for ease of access and safety.

Furthermore, according to figures 5 and 6A, determining an optimized layout (43) of landing points (51) comprises the steps of i) selecting a first cell (43a); ii) analysing a plurality of adjacent second cells (43b); iii) calculating the fractal dimension of each combination of the first cell (43a) with the plurality of adjacent second cells (43b), with a box counting method; iv) selecting a second cell (43b) which creates a highest fractal dimension. A criteria to identify the first cell (43a) to make the process of automatic choice is that the first cell (43a) is chosen randomly in the filtered area. Further added parameters it will be chosen based on the relationship to the landing points (51). It is worth mentioning that fractal dimension is a term used in mathematics to characterize fractals and measure their occupation of space. Some studies have found a correlation between high fractal dimension in natural layouts (savannah, forest patches, etc) and higher biodiversity. The method of the present invention starts from one given first cell (43a), analyses the adjacent ones, calculating the fractal dimension of each combination, and picks the second cell (43b) which creates the highest data point. The process is repeated until reaching the desired total area.

According to a preferred embodiment of the invention, and according to figures 6B and 7, the steps of claim 12 are repeated until covering the total extension of the optimized area (42).

More precisely, according to figures 8A and 8B, the cell (43a, 43b) comprises a structural reef (21) or a plant (22). A criteria to choose the type of element to install in the selected cell (43a, 43b), being structural reef (21) or plants (22), is to distribute them based on factors such as: a) financial aspects of the project to produce artificial reefs (2); b) plants (22) transplantation area requirements provided by the concerned scientist or Biologists involved with the transplantation process of the project; c) bionomical requirements developed from the requirements of the site (1) ecosystem.

The present invention also relates to, according to figure 9, an artificial reef (2) designed by a computer implemented method of designing artificial reefs (2).

The details, shapes, dimensions and other accessory elements, as well as the components used in the computer implemented method of designing artificial reefs, may be conveniently replaced by others that are technically equivalent, and do not depart from the essential nature of the invention or from the scope defined by the claims that are included in the following list.

### List of numerical references:

- 1: site
- 2: artificial reef
- 21: structural reef
- 22: plant
- 3: geographic data
- 31: abiotic data
- 32: biotic data
- 33: terrain data
- 34: logistical data
- 41: restrictions
- 42: optimized area
- 43: optimized layout
- 43a: first cell
- 43b: second cell
- 5: 3D model
- 51: landing point
- 51a: boat
- 51b: sea current
- 51c: shore
- 51d: seabed
- 61: topographic boundary
- 62: intersection event

## Claims

1. Computer implemented method of designing artificial reefs (2), comprising the steps of:
i) analysing geographic data (3) of a selected site (1);
ii) generating of a terrain 3D model (5) of the selected site (1) from the geographic data (3);
iii) determining restrictions (41) in the terrain 3D model (5);
iv) determining an optimized area (42) in the terrain 3D model (5);
v) determining an optimized layout (43) of landing points (51) in the terrain 3D model (5).

2. Computer implemented method of designing artificial reefs (2), according to the claim 1, **characterised in that** the geographic data (3) comprises abiotic data (31) and/or biotic data (32) and/or terrain data (33) and/or project logistical data (34).

3. Computer implemented method of designing artificial reefs (2), according to the claim 2, **characterised in that** the abiotic data (31) comprises any of the group of topography, velocity of currents, direction of currents, height of waves, velocity of wind, direction of wind, direction of waves, turbidity, seabed (51d) substrate type, sediment deposit height, mean depth, seabed (51d) accumulation rate, velocity for species, lighting and protected areas.

4. Computer implemented method of designing artificial reefs (2), according to the claim 2, **characterised in that** the biotic data (32) comprises any of the group of larval dispersion extent, larval dispersion rate, coralliferous habitats, type of species, proximity of existing species and protected species.

5. Computer implemented method of designing artificial reefs (2), according to the claim 2, **characterised in that** the terrain data (33) comprises any of the group of existing ports and diving areas.

6. Computer implemented method of designing artificial reefs (2), according to any of the previous claims, **characterised in that** the terrain 3D model (5) of the selected site (1) is a format of a mesh model or NURBS model.

7. Computer implemented method of designing artificial reefs (2), according to any of the previous claims, **characterised in that** the restrictions (41) in the terrain 3D model (5) are any of the group of required depth, substrate type, protected areas, emissaries presence and seabed (51d) slope.

8. Computer implemented method of designing artificial reefs (2), according to any of the previous claims, **characterised in that** determining an optimized area (42) comprises aligning the landing points (51) along the sea current (51b).

9. Computer implemented method of designing artificial reefs (2), according to any of the previous claims, **characterised in that** determining an optimized area (42) comprises positioning the landing points (51) according to the distance from the shore (51c) and/or to the seabed (51d) type.

10. Computer implemented method of designing artificial reefs (2), according to any of the previous claims, **characterised in that** determining an optimized area (42) comprises determining amount of the landing points (51) based on the number and/or size of the boats (51a) to be moored.

11. Computer implemented method of designing artificial reefs (2), according to any of the previous claims, **characterised in that** determining an optimized area (42) comprises avoiding at least one topographic boundary (61) and/or at least one intersection event (62).

12. Computer implemented method of designing artificial reefs (2), according to any of the previous claims, **characterised in that** determining an optimized layout (43) of landing points (51) comprises the steps of:
i) selecting a first cell (43a);
ii) analysing a plurality of adjacent second cells (43b);
iii) calculating the fractal dimension of each combination of the first cell (43a) with the plurality of adjacent second cells (43b), with a box counting method;
iv) selecting a second cell (43b) which creates a highest fractal dimension.

13. Computer implemented method of designing artificial reefs (2), according to the claim 12, **characterised in that** the steps of claim 12 are repeated until covering the total extension of the optimized area (42).

14. Computer implemented method of designing artificial reefs (2), according to any of the claims 12 to 13, **characterised in that** the cell (43a, 43b) comprises a structural reef (21) or a plant (22).

15. Artificial reef (2) designed by a computer implemented method of designing artificial reefs (2), according to any of the previous claims.
